# EUROPEAN PATENT SPECIFICATION

(11) **EP 4 429 421 B1**
(45) Date of publication and mention of the grant of the patent: **17.12.2025**
(21) Application number: 23846942.3
(22) Date of filing: 24.07.2023
(51) Int. Cl.: H05K 5/02, H01M 50/691, H01M 10/6551, H01M 10/627, H02B 1/052, H02B 1/28

(54) **DIN-RAIL, AND ELECTRONIC COMPONENT ASSEMBLY AND ENERGY STORAGE SYSTEM INCLUDING THE SAME**
DIN-SCHIENE, ELEKTRONISCHE KOMPONENTENANORDNUNG UND ENERGIESPEICHERSYSTEM DAMIT
RAIL DIN, ENSEMBLE COMPOSANT ÉLECTRONIQUE ET SYSTÈME DE STOCKAGE D'ÉNERGIE LE COMPRENANT

(30) Priority: 25.07.2022 KR 20220091541
(43) Date of publication of application: 11.09.2024
(73) Proprietor: LG Energy Solution, Ltd., Seoul 07335 (KR)
(72) Inventor: PARK, Jung-Il, Daejeon 34122 (KR); CHO, Young-Bo, Daejeon 34122 (KR)
(74) Representative: Plasseraud IP
(86) International application number: PCT/KR2023/010681
(87) International publication number: WO 2024/025283

(56) References cited:
- EP-A1- 0 651 483
- EP-A1- 1 944 843
- CN-A- 112 186 516
- CN-U- 213 936 898
- DE-U1- 29 919 130
- JP-A- 2019 029 592
- KR-A- 20140 147 869
- KR-A- 20170 138 198
- KR-A- 20190 022 363
- KR-A- 20190 036 601
- KR-B1- 101 976 347
- US-A1- 2020 075 907

## Description

### TECHNICAL FIELD

The present disclosure relates to a DIN-rail, and an electronic component assembly and an energy storage system including the same. More specifically, the present disclosure relates to a DIN-rail for fixing electronic components, which may prevent deterioration of the insulation performance of electronic components by applying a structure capable of preventing condensation caused by rapid outdoor environmental changes and draining moisture, and an electronic component assembly and an energy storage system including the same.

### BACKGROUND ART

Recently, as issues such as power shortage and eco-friendly energy have emerged, an energy storage system (ESS) for storing generated power has been receiving a lot of attention. Typically, using this energy storage system, it is easy to build a power management system such as a smart grid system, making it possible to easily control power supply in a specific region or city. In addition, as the commercialization of electric vehicles begins in earnest, this energy storage system can also be applied to electric charging stations where electric vehicles can be charged.

The energy storage system may be configured in various forms, but may be typically configured to include one or more battery containers. At this time, the battery container may include a plurality of battery modules connected to each other in series and/or parallel. Here, the plurality of battery modules may be stored inside the battery container through a rack frame or a separate fixing structure. Since the energy storage system including a plurality of battery modules handles a very large amount of power, it essentially includes a circuit breaker that plays a role of protecting circuits and loads by blocking the line when a fault current such as overload, instantaneous current, or phase loss occurs on the electric line, and various electronic components are also included. These electronic components are coupled and fixed to a DIN-rail attached to a switchboard, etc.

However, in existing energy storage systems, there was concern that the insulation performance of electronic components may be deteriorated due to environmental changes or condensation that occurs during the battery cooling process. Therefore, there is a need for a method that can maintain the insulation performance of electronic components and energy storage systems by preventing the inflow of moisture caused by condensation, etc.

Examples of DIN-rails for mounting electronic components are disclosed in documents DE 29919130 U1, JP 2019/029592 A, EP 1944843 A1, CN 213936898 U and CN 112186516 A.

### DISCLOSURE

### Technical Problem

The present disclosure is designed to solve the problems of the related art, and therefore the present disclosure is directed to providing a DIN-rail for fixing electronic components, which may prevent the deterioration of the insulation performance of electronic components by applying a structure capable of preventing moisture from entering the electronic components and effectively draining the moisture even if condensation occurs due to, for example, rapid outdoor environmental changes.

Another object of the present disclosure is to provide an electronic component assembly that can prevent deterioration of insulation performance by including this DIN-rail, and an energy storage system including the same.

### Technical Solution

To this end, the invention relates to a DIN-rail according to claim 1.

The DIN-rail according to embodiments of the invention may present one or more feature(s) of dependent claims 2 to 8, in any combination allowed by the claims.

The invention also relates to an electronic component assembly according to claim 9 or 10.

The invention further relates to an energy storage system according to claims 11 to 13.

### Advantageous Effects

According to one aspect of the present disclosure, in a DIN-rail that couples electronic components through a body unit, the electronic components can be protected from external physical factors by providing a protection unit. For example, it is possible to protect electronic components from moisture generated by condensation due to rapid changes in temperature, and prevent deterioration of the insulation performance of the electronic components by discharging moisture so that it does not come into contact with the electronic components.

According to another aspect of the present disclosure, since the DIN-rail itself also has insulation performance, it is possible to more effectively prevent deterioration of the insulation performance of electronic components.

According to still another aspect of the present disclosure, electronic components can be more effectively protected from physical external factors, and, for example, moisture resulting from condensation caused by rapid changes in temperature or fluid containing such moisture can be collected and discharged more effectively.

According to still another aspect of the present disclosure, fluid discharged through the discharge hole may not affect electronic components during and after discharge. In other words, according to the present disclosure, efficient discharge of fluid is possible by controlling the discharge direction and location of fluid through the discharge hole.

In addition, the present disclosure may have various other effects, and these will be explained in each embodiment, or the explanation will be omitted for effects that can be easily inferred by a person skilled in the art.

### DESCRIPTION OF DRAWINGS

FIG. 1 is a perspective view showing the appearance of a DIN-rail according to an embodiment of the present disclosure.
FIG. 2 is a top view showing the appearance of the DIN-rail according to an embodiment of the present disclosure.
FIG. 3 is a front view showing the appearance of the DIN-rail according to an embodiment of the present disclosure.
FIG. 4 is a diagram showing an exemplary shape of a cross section cut along line A-A' in FIG. 1.
FIG. 5 is a diagram schematically showing an electronic component assembly including the DIN-rail according to an embodiment of the present disclosure.
FIG. 6 is a diagram schematically showing an energy storage system including the electronic component assembly according to an embodiment of the present disclosure.

### BEST MODE

Hereinafter, preferred embodiments of the present disclosure will be described in detail with reference to the accompanying drawings. The accompanying drawings illustrate a preferred embodiment of the present disclosure and together with the foregoing disclosure, serve to provide further understanding of the technical features of the present disclosure, and thus, the present disclosure is not construed as being limited to the drawings. Like reference numerals refer to like elements. Additionally, in the drawings, the thickness, proportions and dimensions of components are exaggerated for effective explanation of technical content.

In this specification, terms indicating directions such as up, down, left, right, front, and back are used, but it is obvious to those skilled in the art of the present disclosure that these terms are only for convenience of explanation and they may vary depending on the location of the target object or the location of the observer.

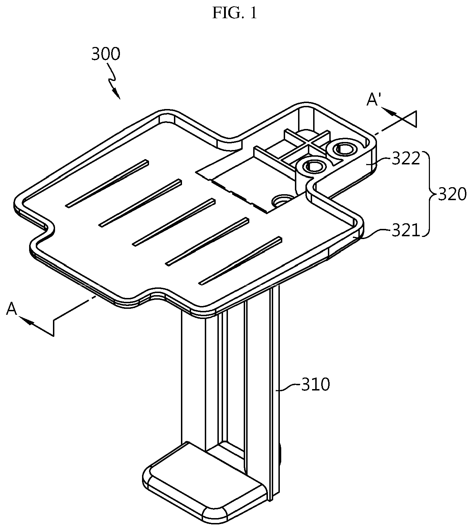

FIG. 1 is a perspective view showing the appearance of a DIN-rail 300 according to an embodiment of the present disclosure.

Referring to FIG. 1, the DIN-rail 300 for fixing electronic components according to an embodiment of the present disclosure includes a body unit 310 and a protection unit 320.

The body unit 310 may be disposed on one side of the electronic component and configured to be coupled with the electronic component. Although not shown in the drawing, a hook structure is provided on one side of the body unit 310 and the electronic component, so that they can be coupled through the hook structure. However, the present disclosure is not limited to such a method of coupling the body unit 310 and the electronic component, and they may be coupled by, for example, screws or bolts and nuts.

The protection unit 320 is connected to the body unit 310 and is configured to cover the upper part of the electronic component, and is configured to discharge fluid so that the fluid falling along the direction of gravity cannot contact the electronic component. The fluid refers to a fluid that may cause problems such as a short circuit when coming into contact with an electronic component, and for example, it may be a fluid containing moisture. The protection unit 320 may have a substantially plate shape to cover the upper part of the electronic component. The protection unit 320 may be configured to cover the entire upper part of the electronic component. The protection unit 320 is equipped with an inclined structure or a discharge hole to discharge the fluid so that the fluid falling in the direction of gravity cannot contact the electronic component. However, the present disclosure does not limit the shape of the protection unit 320.

According to this configuration in the present disclosure, in the DIN-rail 300, which couples electronic components through the body unit 310, the electronic components can be protected from external physical factors by providing the protection unit 320. For example, it is possible to protect electronic components from condensation that occurs due to rapid changes in temperature, and prevent deterioration of the insulation performance of the electronic components by discharging moisture generated by the condensation so that it does not come into contact with the electronic components.

The DIN-rail 300 may contain a resin material. In this case, since the DIN-rail 300 itself also has insulation performance, deterioration of the insulation performance of electronic components can be more effectively prevented. To maximize this effect, the DIN-rail 300 can be made of a resin material.

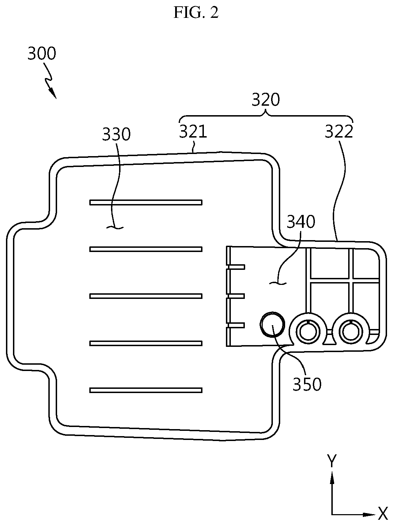

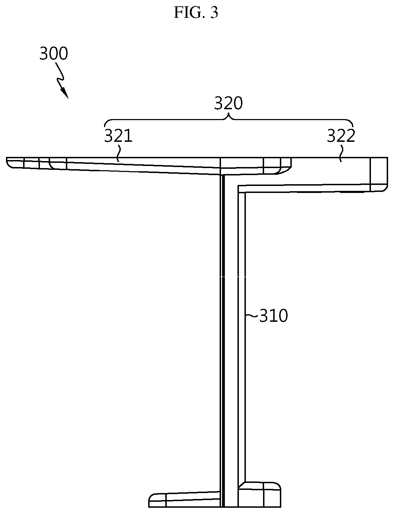

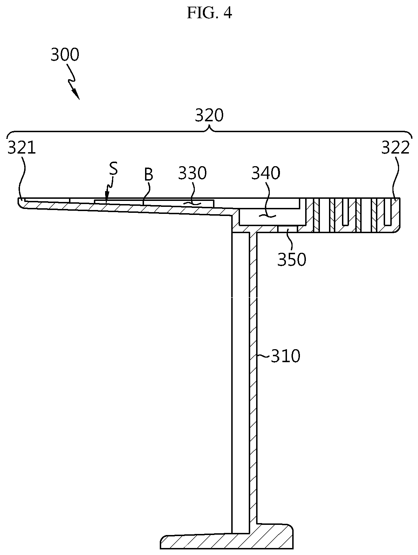

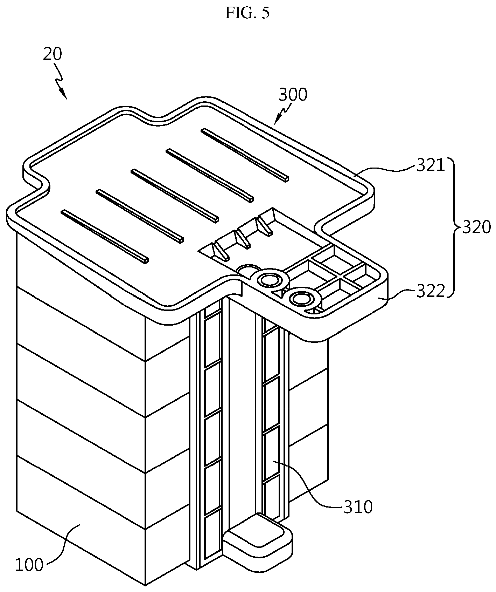

FIG. 2 is a top view showing the appearance of the DIN-rail 300 according to an embodiment of the present disclosure. FIG. 3 is a front view showing the appearance of the DIN-rail 300 according to an embodiment of the present disclosure. FIG. 4 is a diagram showing an exemplary shape of a cross section cut along line A-A' in FIG. 1. FIG. 5 is a diagram schematically showing an electronic component assembly 20 including the DIN-rail 300 according to an embodiment of the present disclosure.

Referring to FIG. 2, the protection unit 320 includes a first portion 321 and a second portion 322.

Referring to FIGS. 2 and 5, the first portion 321 is configured to cover the electronic component 100 and is configured to collect fluid. The first portion 321 may have a shape that roughly corresponds to the shape of the upper part of the electronic component 100 so as to effectively cover the electronic component 100. In this case, when viewed from above according to the direction of gravity, the area of the first portion 321 may be larger than the area of the electronic component 100 so that the electronic component 100 is not exposed to the outside of the first portion 321.

The second portion 322 extends from the first portion 321 to the outside of the electronic component 100 and is be configured to discharge the fluid collected by the first portion 321. Referring to FIGS. 2 and 5, the second portion 322 may be formed to extend integrally with the first portion 321, for example. The second portion 322 is configured so that the fluid collected in the first portion 321 is discharged in the direction of gravity from an extended end located opposite to the first portion 321 with respect to the body unit 310, for example.

According to this configuration of the present disclosure, the electronic component 100 can be more effectively protected from physical external factors, and moisture caused by condensation caused by rapid changes in temperature or fluid containing such moisture can be collected and discharged more effectively.

Referring to FIGS. 2 to 5, the first portion 321 may include a first collection space 330 that is embedded in a direction toward the electronic component 100. The first collection space 330 may be configured such that its internal area other than the perimeter of the first portion 321 is embedded. At least a portion of the bottom surface B of the first collection space 330 may have a downward sloping shape toward the second portion 322. That is, the bottom surface B of the first collection space 330 may include an inclined portion S that is inclined downward along the direction toward the second portion 322. However, the shape of the inclined portion S in the present disclosure is not limited to this, and the inclined portion S may have, for example, a shape in which the bottom surface B of the first collection space 330 is inclined downward along the direction from both ends of the Y-axis extending direction toward the center and also is simultaneously inclined downward in the direction toward the second portion (the positive direction of the X-axis).

Referring to FIGS. 2 to 4, the second portion 322 may include a second collection space 340 configured to communicate with the first collection space 330. The second collection space 340 may be formed deeper than the first collection space 330. Due to the inclined shape of the bottom surface B of the first collection space 330, the fluid is collected, and the fluid may flow to the second collection space 340 by gravity and be collected again.

A discharge hole 350 configured to discharge fluid may be formed in the bottom of the second collection space 340. The discharge hole 350 may be formed in an area corresponding to the opposite side of the electronic component based on the body unit 310. The fluid collected again in the second collection space 340 can be discharged through the discharge hole 350.

According to this configuration of the present disclosure, the fluid discharged through the discharge hole 350 may not affect the electronic component during and after discharge. The fluid can be efficiently discharged by controlling the discharge direction and location of fluid through the discharge hole 350.

Referring to FIG. 5, the electronic component assembly 20 according to an embodiment of the present disclosure may include an electronic component 100 and the DIN-rail 300 according to the present disclosure. In particular, the electronic component 100 may be a circuit breaker.

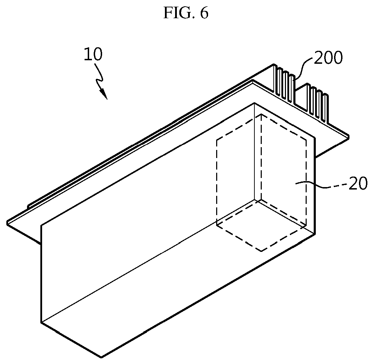

FIG. 6 is a diagram schematically showing an energy storage system 10 including the electronic component assembly 20 according to an embodiment of the present disclosure.

Referring to FIG. 6, the energy storage system 10 according to an embodiment of the present disclosure may include a battery pack including a plurality of secondary batteries, a heat sink 200 coupled to the battery pack and configured to cool the battery pack, and the above-described electronic component assembly 20 according to present disclosure.

The electronic component assembly 20 included in the energy storage system 10 according to an embodiment of the present disclosure may be coupled to at least one of the battery pack and the heat sink 200. Additionally, the electronic component assembly 20 may be located lower than the heat sink 200 along the direction of gravity.

As such, the energy storage system 10 including the electronic component assembly 20 according to this embodiment may include various other components included in the energy storage system in addition to the DIN-rail 10 or the electronic component assembly 20.

### [Reference numerals]

10: energy storage system
20: electronic component assembly
100: electronic component
200: heat sink
300: DIN-rail
310: body unit
320: protection unit
321: first portion
322: second portion
330: first collection space
340: second collection space
350: discharge hole
B: bottom surface
S: inclined portion

## Claims

1. A DIN-rail (300) for fixing an electronic component (100), comprising:
a body unit (310) disposed on one side of the electronic component (100) and configured to be coupled with the electronic component (100); and
a protection unit (320) connected to the body unit (310), configured to cover the upper part of the electronic component (100) when the body unit (310) is disposed substantially along the direction of gravity, and configured to discharge fluid so that the fluid falling along the direction of gravity does not contact the electronic component (100),
**characterized in that** the protection unit (320) includes:
a first portion (321) configured to cover the electronic component (100) and configured to collect the fluid; and
a second portion (322) configured to extend from the first portion (322) to the outside of the electronic component (100) and configured to discharge fluid collected by the first portion (321), from an extended end located opposite the first portion (321) with respect to the body unit (310).

2. The DIN-rail (300) according to claim 1, wherein when viewed from above along the direction of gravity, the area of the first portion (321) is larger than the area of the electronic component (100) so that the electronic component (100) is not exposed to the outside of the first portion (321).

3. The DIN-rail (300) according to claim 1, wherein the first portion (321) has a first collection space (330) with an embedded shape in a direction toward the electronic component (100).

4. The DIN-rail (300) according to claim 3, wherein the bottom surface (B) of the first collection space (330) has a downward sloping shape toward the second portion (322).

5. The DIN-rail (300) according to claim 3, wherein the second portion (322) has a second collection space (340) configured to communicate with the first collection space (330), and
wherein a discharge hole (350) is formed in the bottom surface of the second collection space (340) to discharge the fluid.

6. The DIN-rail (300) according to claim 5, wherein the second collection space (340) is formed deeper than the first collection space (330).

7. The DIN-rail (300) according to claim 5, wherein the discharge hole (350) is formed in the area corresponding to the opposite side of the electronic component (100) based on the body unit (310).

8. The DIN-rail (300) according to claim 1, wherein the DIN-rail (300) contains a resin material.

9. An electronic component assembly (20), comprising:
an electronic component (100); and
the DIN-rail (300) according to any one of claims 1 to 8, which is coupled to the electronic component (100).

10. The electronic component assembly (20) according to claim 9, wherein the electronic component (100) is a circuit breaker.

11. An energy storage system (10), comprising:
a battery pack including a plurality of secondary batteries;
a heat sink (200) coupled to the battery pack and configured to cool the battery pack; and
the electronic component assembly (20) according to claim 9, which is configured to collect and discharge fluid generated from the heat sink (200).

12. The energy storage system (10) according to claim 11, wherein the electronic component assembly (20) is coupled to at least one of the battery pack and the heat sink (200).

13. The energy storage system (20) according to claim 11, wherein the electronic component assembly (20) is located lower than the heat sink (200) along the direction of gravity.

## Patentansprüche

1. DIN-Schiene (300) zum Befestigen einer elektronischen Komponente (100), umfassend:
eine Körpereinheit (310), welche an einer Seite der elektronischen Komponente (100) angeordnet und dazu eingerichtet ist, mit der elektronischen Komponente (100) gekoppelt zu sein; und
eine Schutzeinheit (320), welche mit der Körpereinheit (310) verbunden ist, welche dazu eingerichtet ist, den oberen Teil der elektronischen Komponente (100) zu bedecken, wenn die Körpereinheit (310) im Wesentlichen entlang der Richtung der Schwerkraft angeordnet ist, und dazu eingerichtet ist, Fluid abzugeben, so dass das Fluid, welches entlang der Richtung der Schwerkraft fällt, nicht in Kontakt mit der elektronischen Komponente (100) kommt,
**dadurch gekennzeichnet, dass** die Schutzeinheit (320) umfasst:
einen ersten Abschnitt (321), welcher dazu eingerichtet ist, die elektronische Komponente (100) zu bedecken, und dazu eingerichtet ist, das Fluid zu sammeln; und
einen zweiten Abschnitt (322), welcher dazu eingerichtet ist, sich von dem ersten Abschnitt (322) zu der Außenseite der elektronischen Komponente (100) zu erstrecken, und dazu eingerichtet ist, Fluid abzugeben, welches von dem ersten Abschnitt (321) gesammelt wird, von einem Erstreckungsende, welches entgegengesetzt zu dem ersten Abschnitt (321) bezüglich der Körpereinheit (310) angeordnet ist.

2. DIN-Schiene (300) nach Anspruch 1, wobei von oberhalb entlang der Richtung der Schwerkraft betrachtet, die Fläche des ersten Abschnitts (321) größer als die Fläche der elektronischen Komponente (100) ist, so dass die elektronische Komponente (100) nicht zu der Außenseite des ersten Abschnitts (321) freigelegt ist.

3. DIN-Schiene (300) nach Anspruch 1, wobei der erste Abschnitt (321) einen ersten Sammelraum (330) mit einer eingebetteten Form in einer Richtung zu der elektronischen Komponente (100) hin aufweist.

4. DIN-Schiene (300) nach Anspruch 3, wobei die untere Fläche (B) des ersten Sammelraums (330) eine nach unten abschüssige Form in Richtung des zweiten Abschnitts (322) aufweist.

5. DIN-Schiene (300) nach Anspruch 3, wobei der zweite Abschnitt (322) einen zweiten Sammelraum (340) aufweist, welcher dazu eingerichtet ist, mit dem ersten Sammelraum (330) zu kommunizieren, und
wobei ein Abgabeloch (350) in der unteren Fläche des zweiten Sammelraums (340) gebildet ist, um das Fluid abzugeben.

6. DIN-Schiene (300) nach Anspruch 5, wobei der zweite Sammelraum (340) tiefer als der erste Sammelraum (330) gebildet ist.

7. DIN-Schiene (300) nach Anspruch 5, wobei das Abgabeloch (350) in der Fläche gebildet ist, welche der entgegengesetzten Seite der elektronischen Komponente (100) entspricht, auf Grundlage der Körpereinheit (310).

8. DIN-Schiene (300) nach Anspruch 1, wobei die DIN-Schiene (300) ein Harzmaterial enthält.

9. Elektronische Komponentenanordnung (20), umfassend:
eine elektronische Komponente (100); und
die DIN-Schiene (300) nach einem der Ansprüche 1 bis 8, welche mit der elektronischen Komponente (100) gekoppelt ist.

10. Elektronische Komponentenanordnung (20) nach Anspruch 9, wobei die elektronische Komponente (100) ein Schutzschalter ist.

11. Energie-Speichersystem (10), umfassend:
einen Batteriepack, welcher eine Mehrzahl von Sekundärbatterien umfasst;
eine Wärmesenke (200), welche mit dem Batteriepack gekoppelt und dazu eingerichtet ist, den Batteriepack zu kühlen; und
die elektronische Komponentenanordnung (20) nach Anspruch 9, welche dazu eingerichtet ist, von der Wärmesenke (200) erzeugtes Fluid zu sammeln und abzugeben.

12. Energie-Speichersystem (10) nach Anspruch 11, wobei die elektronische Komponentenanordnung (20) mit wenigstens einem aus dem Batteriepack und der Wärmesenke (200) gekoppelt ist.

13. Energie-Speichersystem (20) nach Anspruch 11, wobei die elektronische Komponentenanordnung (20) niedriger als die Wärmesenke (200) entlang der Richtung der Schwerkraft angeordnet ist.

## Revendications

1. Rail DIN (300) pour la fixation d'un composant électronique (100), comprenant :
une unité de corps (310) disposée sur un côté du composant électronique (100) et configurée pour être couplée au composant électronique (100) ; et
une unité de protection (320) reliée à l'unité de corps (310), configurée pour recouvrir la partie supérieure du composant électronique (100) lorsque l'unité de corps (310) est disposée sensiblement le long de la direction de gravité, et configurée pour évacuer un fluide de sorte que le fluide tombant le long de la direction de gravité n'entre pas en contact avec le composant électronique (100),
**caractérisé en ce que** l'unité de protection (320) comporte :
une première partie (321) configurée pour recouvrir le composant électronique (100) et configurée pour collecter le fluide ; et
une deuxième partie (322) configurée pour s'étendre à partir de la première partie (322) vers l'extérieur du composant électronique (100) et configurée pour décharger le fluide collecté par la première partie (321), à partir d'une extrémité étendue située en face de la première partie (321) par rapport à l'unité de corps (310).

2. Rail DIN (300) selon la revendication 1, dans lequel, lorsqu'elle est vue de dessus le long de la direction de gravité, l'aire de la première partie (321) est plus grande que l'aire du composant électronique (100) de sorte que le composant électronique (100) ne soit pas exposé à l'extérieur de la première partie (321).

3. Rail DIN (300) selon la revendication 1, dans lequel la première partie (321) présente un premier espace de collecte (330) avec une forme encastrée dans une direction vers le composant électronique (100).

4. Rail DIN (300) selon la revendication 3, dans lequel la surface inférieure (B) du premier espace de collecte (330) présente une forme inclinée vers le bas vers la deuxième partie (322).

5. Rail DIN (300) selon la revendication 3, dans lequel la deuxième partie (322) présente un deuxième espace de collecte (340) configuré pour communiquer avec le premier espace de collecte (330), et
dans lequel un orifice d'évacuation (350) est formé dans la surface inférieure du deuxième espace de collecte (340) pour évacuer le fluide.

6. Rail DIN (300) selon la revendication 5, dans lequel le deuxième espace de collecte (340) est formé de façon à être plus profond que le premier espace de collecte (330).

7. Rail DIN (300) selon la revendication 5, dans lequel le trou d'évacuation (350) est formé dans la zone correspondant au côté opposé du composant électronique (100) sur la base de l'unité de corps (310).

8. Rail DIN (300) selon la revendication 1, dans lequel le rail DIN (300) contient un matériau en résine.

9. Ensemble composant électronique (20) comprenant :
un composant électronique (100) ; et
le rail DIN (300) selon l'une quelconque des revendications 1 à 8, qui est couplé au composant électronique (100).

10. Ensemble composant électronique (20) selon la revendication 9, dans lequel le composant électronique (100) est un disjoncteur.

11. Système de stockage d'énergie (10), comprenant :
un bloc-batterie comportant une pluralité de batteries secondaires ;
un dissipateur thermique (200) couplé au bloc-batterie et configuré pour refroidir le bloc-batterie ; et
l'ensemble composant électronique (20) selon la revendication 9, qui est configuré pour collecter et évacuer le fluide généré par le dissipateur thermique (200).

12. Système de stockage d'énergie (10) selon la revendication 11, dans lequel l'ensemble composant électronique (20) est couplé à au moins un parmi le bloc-batterie et le dissipateur thermique (200).

13. Système de stockage d'énergie (20) selon la revendication 11, dans lequel l'ensemble composant électronique (20) est situé plus bas que le dissipateur thermique (200) dans la direction de gravité.
